# EUROPÄISCHE PATENTSCHRIFT

(11) **EP 3 752 306 B1**
(45) Veröffentlichungstag und Bekanntmachung des Hinweises auf die Patenterteilung: **21.06.2023**
(21) Anmeldenummer: 19706473.6
(22) Anmeldetag: 14.02.2019
(51) Int. Cl.: C23C 24/08, F16G 13/06, B22F 7/04, C22C 29/16

(54) **METALLBAUTEIL UND HERSTELLUNGSVERFAHREN DAVON**
METAL COMPONENT AND METHOD FOR PRODUCING SAME
COMPOSANT MÉTALLIQUE ET SON PROCÉDÉ DE FABRICATION

(30) Priorität: 14.02.2018 DE 102018103319
(43) Veröffentlichungstag der Anmeldung: 23.12.2020
(73) Patentinhaber: iwis mobility systems GmbH & Co. KG, 81369 München (DE)
(72) Erfinder: WATZINGER, Bernd, 81829 MÜNCHEN (DE); BURGER, Matija, 82205 Gilching (DE)
(74) Vertreter: Dantz, Dirk
(86) Internationale Anmeldenummer: PCT/EP2019/053747
(87) Internationale Veröffentlichungsnummer: WO 2019/158668

(56) Entgegenhaltungen:
- JP-B2- 3 018 804
- US-A- 4 327 134
- US-A1- 2010 120 567
- US-A1- 2017 058 997

## Beschreibung

Die Erfindung betrifft ein wie im beigefügten Anspruchssatz beschriebenes Verfahren zur Herstellung eines mit einer Hartstoffschicht beschichteten Metallbauteils, das die Verfahrensschritte Aufbereiten eines Trennmittels, Zufügen des aufbereiteten Trennmittels zu einer Pulvermischung, Bereitstellen der Pulvermischung, Bereitstellen des Substrats aus Metall, Heizen des Pulvers und des Substrats in einer Heizvorrichtung, Abscheiden einer Schicht auf dem Substrat, wobei die Schicht eine höhere Härte aufweist als das Substrat, und Abkühlen des Substrats, sowie ein wie im beigefügten Anspruchssatz beschriebenes Metallbauteil mit einer Hartstoffschicht.

### Stand der Technik

Gelenkketten mit jeweils über ein Kettengelenk miteinander verbundenen Kettengliedern sind in vielfältiger Form im Einsatz. Im Betrieb als Antriebs- oder Förderketten wird insbesondere der Bereich der Kettengelenke so stark beansprucht, dass ein Bedarf an einer verschleißbeständigen Lagerfläche besteht. Auch ist es insbesondere im Hinblick auf hohe Stückzahlen sinnvoll, aufwändige Lösungen durch kostengünstige Beschichtungsverfahren und -prozesse zu ersetzen.

DE 10 2005 047 449 A1 stellt eine verschleissverbesserte Gliederkette vor, deren Kettenbolzen bzw. Kettenhülsen mit Hartstoffbeschichtungen versehen sind. Diese Beschichtungen sind mittels PVD-Verfahren (PVD: Physical Vapour Deposition) aufgebracht. Die Hartstoffschicht weist eine Dicke von 1 bis 10 µm auf und kann weiterhin mit einer Gleitstoffschicht, z.B. PTFE, umgeben sein.

Die US 2017/058 997 A1 beschreibt ein Verfahren zur Abscheidung von CrN-Schichten auf Kettenbauteilen. Der Einfluss des Trennmittels auf die Verschleißfestigkeit und die Lebensdauer wird allerdings hier nicht betrachtet.

Die US 2010/120 567 A1 beschreibt ein Verfahren zur Abscheidung von VC-Schichten auf Kettenbauteilen. Bei der Herstellung wird ein die Sinterung des Metallpulver verhinderndes Material beschrieben.

Die JP 3 018 804 B2 beschreibt ein Verfahren zur Abscheidung von TiAI-Schichten auf Stahlsubstraten. Für das Verfahren wird ein Trennmittel mit einer Korngröße von 80 - 200 mesh (74 µm - 177 µm) verwendet und ein Anteil von 78 Gew.% an der Pulvermischung. Ein Zusammenhang des verwendeten Trennmittels mit der Lebensdauer oder Verschleißfestigkeit wird nicht beschrieben.

Die US 4 327 134 A beschreibt ein Abscheidungsverfahren, dass zwei unterschiedliche Pulvermischungen verwendet. Die erste Pulvermischung bildet ein Bett auf der das Substrat mit einer zweiten Pulvermischung platziert wird. Das Substrat kommt hierbei lediglich mit der zweiten Pulvermischung in Berührung. Die Korngröße des Trennmittels der ersten Pulvermischung liegt hier zwischen 100 µm und 300 µm. Der Einfluss des Trennmittels auf die Verschleißfestigkeit der Hartstoffschicht bleibt unerkannt.

In der Schrift DE 10 2006 052 869 A1 wird eine Gliederkette beschrieben, deren Gelenkfläche des Bolzens und der Hülse mit einer PVD-Hartstoffschicht versehen ist. Dabei bestehen Bolzen und Hülse aus einem hochkohlenstoffhaltigen Stahl mit einem Kohlenstoffanteil zwischen 0,4 Gew.-% und 1,2 Gew.-%.

DE 10 2011 006 294 A1 stellt ein Verfahren zur Herstellung eines gehärteten beschichteten Metallbauteils vor. Das Metallbauteil wird zur Anreicherung von Kohlenstoff und/oder Stickstoff in der Randschicht wärmebehandelt und danach auf eine Temperatur unterhalb der Martensitbildung abgeschreckt. Dann wird das Metallbauteil auf eine höhere Temperatur angelassen als die Temperatur, bei der der nachfolgende Beschichtungsprozess stattfindet. Die Beschichtung selbst erfolgt durch CVD- oder PVD-Verfahren (CVD: Chemical Vapour Deposition).

In DE 10 2013 222 244 A1 wird eine Kettenlasche für eine Kette beschrieben, die mit einer reibungsmindernden tribologischen Beschichtung versehen ist. Die Beschichtung wird durch PVD- oder PACVD-Verfahren aufgetragen.

DE 10 2016 215 709 A1 zeigt Kettenkomponenten wie Hülsen, Laschen, Bolzen und Rollen aus Stahl, die mit einer verschleissmindernden CrN-Schicht versehen sind. Die CrN-Schicht wird durch ein CVD-Verfahren hergestellt. Der Stickstoff wird dabei aus dem ggf. vor der Behandlung nitrierten Stahl bezogen.

Ein Gelenk für eine Rollen- oder Hülsenkette wird in WO 2014019699 A1 vorgestellt. Eine nitridische oder karbidische Hartstoffschicht wird mittels PVD- oder CVD-Verfahren auf das Gelenk aufgetragen.

Die genannten Lösungen zur Herstellung eines gehärteten beschichteten Metallbauteils weisen Nachteile auf. PVD-Verfahren benötigen einen Arbeitsdruck von 10-4 bis 10 Pa und werden bei Arbeitstemperaturen von abhängig von der Art der Beschichtung bei mehreren hundert °C betrieben. PVD-Verfahren stellen also hohe Anforderungen an die Beschichtungskammer. Außerdem sind sie nicht schüttgut-tauglich. Substrat und abzuscheidendes Material (Target) sind räumlich in der Beschichtungskammer getrennt. PVD-Verfahren sind sog. Sichtlinienprozesse, d.h. nur die vom Target aus sichtbaren Flächen werden beschichtet. Innen liegende Flächen oder Bohrungen werden dünner beschichtet. Bei der Verwendung von Trennmittel besteht zudem bei allen Pulververfahren die Gefahr, dass Bestandteile des Trennmittels in die Hartstoffschicht eingebaut werden. Dies kann zu einer Beschädigung der Hartstoffschicht und zu Beeinträchtigungen der Leistungsfähigkeit der Hartstoffschicht führen.

Es ist daher Aufgabe der vorliegenden Erfindung, ein Verfahren zur Herstellung eines gehärteten beschichteten Metallbauteils vorzugsweise ein Stahlbauteil bereitzustellen, insbesondere einer Metallnitrid- oder Metallcarbid-Schicht, das einfach anzuwenden ist, die Beschichtung von hohen Stückzahlen pro Zeiteinheit ermöglicht und kostengünstig zu betreiben ist. Gleichzeitig wird eine ausreichend hohe Qualität der Hartstoffschicht dadurch gewährleistet werden, dass bei Verwendung von Trennmitteln der Einbau von Bestandteilen des Trennmittels in die Hartstoffschicht vermieden wird.

Die Aufgabe wird durch das erfindungsgemäße Verfahren gemäß Anspruch 1 und das Metallbauteil gemäß Anspruch 4 gelöst. Weitere vorteilhafte Ausbildungen der Erfindung sind in den Unteransprüchen dargelegt.

Das erfindungsgemäße Verfahren zur Herstellung eines mit einer Hartstoffschicht beschichteten Metallbauteils weist bis zu sieben Verfahrensschritte auf. Im ersten Verfahrensschritt wird ein Trennmittel aufbereitet. Im zweiten Verfahrensschritt wird das aufbereitete Trennmittel einer Pulvermischung zugefügt. Im dritten Verfahrensschritt wird die Pulvermischung bereitgestellt.

Im vierten Verfahrensschritt wird das Substrat bestehend aus einem Metall bereitgestellt. Im fünften Verfahrensschritt werden Pulvermischung und Substrat in einer Heizvorrichtung aufgeheizt. Im sechsten Verfahrensschritt wird eine Schicht auf dem Substrat abgeschieden. Die abgeschiedene Schicht weist eine höhere Härte als das Substrat auf. Im siebten Verfahrensschritt wird das Substrat abgekühlt. Anschließend können noch die Verfahrensschritte Härten, Anlassen und Gleitschleifen folgen.

Durch CVD-Beschichtung (Chemical Vapour Deposition) wird eine harte Schicht auf dem Substrat aus kohlenstoffhaltigem Stahl abgeschieden, die eine große Abrieb- und Verschleißfestigkeit, eine große Härte und Temperaturbeständigkeit, eine geringe Reibung sowie gute chemische Eigenschaften und eine geringe Haftneigung aufweist. Neben der Verbesserung der Verschleißbeständigkeit erhöht die Hartstoffschicht auch die Korrosionsbeständigkeit. Dabei werden vorzugsweise kohlenstoffhaltige Stähle als Substrat verwendet, da diese Stähle eine ausreichende Festigkeit und Anlassbeständigkeit aufweisen. Die Hartstoffschicht kommen sowohl metallische als auch nichtmetallische Hartstoffen zur Anwendung. Vorzugsweise ist die Hartstoffschicht u.a. aus Karbiden,

Nitriden, Karbonitriden, Boriden und Silziden der Übergangsmetalle, z.B. Vanadium, Chrom, Wolfram, Zirkonium, Titan aufgebaut. Als nichtmetallische Hartstoffe sind z.B. Diamant und DLC (Diamond Like Carbon) sowie Korund, Borkabid, kubisches Bornitrid, Siliziumcarbid oder Aluminiumnitrid geeignet. In einer bevorzugten Ausgestaltung der Erfindung ist das Substrat ein Stahlsubstrat und die Hartstoffschicht eine Karbid-, Nitrid- und/oder Karbonitrid-Schicht.

Das CVD-Verfahren bietet Vorteile gegenüber dem aus dem Stand der Technik bekannten PVD-Verfahren zur Erzeugung einer Hartstoffschicht. Das CVD-Verfahren ist gegenüber dem PVD-Verfahren schüttgut-tauglich und bietet wirtschaftliche Vorteile hinsichtlich Anlagentechnik, Bedienung und Prozesstechnik: Das zu beschichtende Substrat wird z.B. in einer Drehtrommel mit dem Pulver vermengt. Der Beschichtungsprozess erfolgt in mehreren Stunden bei einer bestimmten Prozesstemperatur. Alle erreichbaren Flächen des Substrates werden gleichmäßig beschichtet, auch enge Bohrungen. Am Ende des Beschichtungsprozesses wird das beschichtete Substrat abgekühlt. Beim PVD-Verfahren sind Substrat und das abzuscheidende Material nachteilig räumlich getrennt, die Beschichtung erfolgt durch Verdampfen des abzuscheidenden Materials bei Arbeitsdrucken von 10-4 bis 10 Pa.

Erfindungsgemäß enthält die Pulvermischung ein inertes Trennmittel, z.b. Al₂O₃. Das Trennmittel dient der Trockenhaltung der Pulvermischung, um eine Verklumpung zu verhindern. Außerdem werden Metall-Ansinterungen und Versinterungen während des Beschichtungsprozesses vermieden. Partikel des Trennmittels werden während des CVD-Prozesses in die Hartstoffschicht eingelagert und verhindern so die Bildung einer homogenen Hartstoffschicht. Um den Anteil des Trennmittels in der Hartstoffschicht so gering wie möglich zu halten, bestehen grundsätzlich zwei Möglichkeiten. Der Anteil des Trennmittels in der Pulvermischung wird vermindert. Zusätzlich wird das Trennmittel so aufbereitet, dass die Teilchengrößenverteilung des Trennmittels in der Pulvermischung möglichst groß ist und nur noch geringe Feinanteile aufweist. Durch die mechanische Reibung während des Beschichtungsprozesses werden große Partikel von der Hartstoffschicht leichter abgelöst als kleine Partikel, sobald sie auf dem Substrat anhaften. Weiterführende Ausbildungen der Erfindung zur Hartstoffschicht sind in den Unteransprüchen 2 und 3 dargelegt.

Erfindungsgemäß beträgt der Anteil des Trennmittels an der Pulvermischung kleinergleich 25 Gew.-% und bevorzugt kleinergleich als 20 Gew.-%. Der Anteil des Trennmittels an der Pulvermischung wird möglichst gering gehalten, um die Einlagerung des Trennmittels in der Hartstoffschicht zur vermindern.

In einer Weiterbildung der Erfindung beträgt der Anteil des Al in der Hartstoffschicht kleiner 10 Atom%, bevorzugt kleiner 5 Atom% und besonders bevorzugt kleiner 3 Atom%.

Erfindungsgemäß beinhaltet der Verfahrensschritt Aufbereiten eines Trennmittels eine Veränderung der Teilchengrößenverteilung. Das Trennmittel wird so aufbereitet, dass die Teilchengrößenverteilung des Trennmittels in der Pulvermischung möglichst groß ist. Durch die mechanische Reibung während des Beschichtungsprozesses werden große Partikel von der Hartstoffschicht leichter abgelöst als kleine Partikel, sobald sie auf dem Substrat anhaften. Zudem werden kleinere Partikel des Trennmittels leichter von einer aufwachsenden Schicht umschlossen und in die Hartstoffschicht eingebaut.

Erfindungsgemäß erfolgt die Veränderung der Teilchengrößenverteilung durch Sieben, Sedimentation, Filtrieren und/oder Zentrifugieren, Sichten und/oder Windsichten.

Erfindungsgemäß beinhaltet das Aufbereiten des Trennmittels ein Waschen des Trennmittels. Waschen ist für Sedimentation bzw. Filtrieren und Trocknen des Trennmittels zur Veränderung der der Teilchengrößenverteilung notwendig.

Erfindungsgemäß beinhaltet das Trennmittel einen Anteil an Partikeln mit einer Partikelgröße kleiner 40 µm von weniger als 25%, bevorzugt weniger als 15% und besonders bevorzugt weniger als 10%. Der Anteil von Partikeln mit einer Größe von mehr als 40 µm soll möglichst hoch sein, damit durch die mechanische Reibung während des Beschichtungsprozesses große Partikel von der Hartstoffschicht leichter abgelöst werden als kleine Partikel, sobald sie auf dem Substrat anhaften.

In einer weiteren Ausgestaltung der Erfindung beinhaltet das Trennmittel einen Anteil an Partikeln mit einer Partikelgröße kleiner 10 µm von weniger als 20%, bevorzugt weniger als 12% und besonders bevorzugt weniger als 8%. Bei einer üblicherweise erzielten Schichtdicke der Hartstoffschicht von 1 - 25 µm werden kleinere Partikel des Trennmittels nicht oder nur schwer abgelöst, sobald sie auf dem Substrat anhaften. Der Anteil an diesen besonders kleinen Partikeln kleiner 10 µm wird daher so gering wie möglich eingestellt.

In einer weiteren Ausbildung der Erfindung beinhaltet das Trennmittel Al₂O₃. Al₂O₃ ist ein inerter Feststoff mit hohem Schmelzpunkt und hoher Härte und verhindert Ansinterungen. Außerdem ist Al₂O₃ kostengünstig verfügbar. Weitere mögliche Trennmittel sind Kaolin (Aluminiumsilikat), Mullit (Aluminium- und Siliciumoxid), Zirkonoxid, nitridische und/oder silicide Keramiken und/oder sämtliche weitere keramische inerte Substanzen.

Erfindungsgemäß ist die Prozesstemperatur des erfindungsgemäßen Verfahrens zumindest teilweise höher als 450°C, bevorzugt höher als 500°C und besonders bevorzugt höher als 550°C. Diese hohen Temperaturen sind notwendig, um die Reaktion im CVD-Verfahren zur Bildung der Hartstoffschicht ablaufen zu lassen.

Die erfindungsgemäße Aufgabe wird weiterhin durch ein Metallbauteil gemäß Anspruch 4 gelöst.

Das erfindungsgemäße Metallbauteil beschichtet mit einer Hartstoffschicht weist ein Substrat aus Stahl sowie eine Hartstoffschicht aus einem Metallcarbid und/oder einem Metallnitrid bzw. deren Mischungen auf. Die Hartstoffschicht weist ebenfalls Partikel eines Trennmittels auf. Erfindungsgemäß beträgt der mittels eines Schliffbildes der Hartstoffschicht festgestellte Flächenanteil der Partikel des Trennmittels in der Hartstoffschicht kleiner als 15%, bevorzugt kleiner als 10% und besonders bevorzugt kleiner als 5%. Durch die Aufbereitung des Trennmittels durch z.B. Sieben wird der Flächenanteil der Partikel des Trennmittels in der Hartstoffschicht gegenüber aus dem Stand der Technik bekannten Lösungen reduziert und so eine deutlich homogenere Hartstoffschicht erzielt.

In einer Weiterbildung der Erfindung beträgt der Anteil des Al in der Hartstoffschicht kleiner 10 Atom%, bevorzugt kleiner 5 Atom% und besonders bevorzugt kleiner 3 Atom%.

Erfindungsgemäß ist das Substrat ein Kettenbauteil, z.B. eine Innen- und/oder Außenlasche, eine Hülse und/oder ein Bolzen eines Kettenbauteils. Die Kette weist Außenlaschen auf, die durch Innenlaschen verbunden sind. Bolzen sind in jeweils einer Hülse drehbar gelagert. Bolzen und Hülse sind im Betrieb hohem Verschleiß ausgesetzt und daher besonders für die Beschichtung mit einer Hartstoffschicht geeignet. Die Hartstoffschicht auf der Gelenkfläche des Bolzens und/oder der Hülse weist eine Schichtdicke zwischen 1 und 40 µm auf. Trotz dieser geringen Schichtdicke ermöglichen diese Hartstoffschichten auf der Gelenkfläche des Bolzens und/oder der Hülse einen korrosiven Schutz und eine gute Verschleißbeständigkeit. Dabei ist es ausreichend, wenn der Kontaktbereich zwischen Bolzen und der Hülse mit der Hartstoffschicht versehen ist.

Erfindungsgemäß ist das Substrat ein Kettenbauteil, z.B. eine Innen- und/oder Außenlasche, eine Hülse und/oder ein Bolzen eines Kettenbauteils. Die Kette weist Außenlaschen auf, die durch Innenlaschen verbunden sind. Bolzen sind in jeweils einer Hülse drehbar gelagert. Bolzen und Hülse sind im Betrieb hohem Verschleiß ausgesetzt und daher besonders für die Beschichtung mit einer Hartstoffschicht geeignet. Gegenüber herkömmlichen Schutzschichten ist es bei der Verwendung einer Hartstoffschicht in einer Kette ausreichend, wenn die Hartstoffschicht auf der Gelenkfläche des Bolzens und/oder der Hülse eine Schichtdicke zwischen 1 und 40 µm aufweist. Trotz dieser geringen Schichtdicke ermöglichen diese Hartstoffschichten auf der Gelenkfläche des Bolzens und/oder der Hülse einen guten korrosiven Schutz und eine gute Verschleißbeständigkeit. Dabei ist es ausreichend, wenn der Kontaktbereich zwischen Bolzen und der Hülse mit der Hartstoffschicht versehen ist. In einer bevorzugten Ausführungsform der Erfindung ist das Kettenbauteil aus einem kohlenstoffhaltigen Stahl. Beispiele aus dem bisherigen Stand der Technik und Ausführungsbeispiele der erfindungsgemäßen Sensorvorrichtung und des erfindungsgemäßen Verfahrens sind in den Zeichnungen schematisch vereinfacht dargestellt und werden in der nachfolgenden Beschreibung näher erläutert.

Es zeigen:
- Fig. 1:: Aufbau einer Kette zur Verwendung in Kettenantrieben
- Fig. 2:: Prozess der Hartstoffschicht-Bildung durch CVD-Verfahren aus dem Stand der Technik ohne vorherige Aufbereitung des Trennmittels
- Fig. 3:: Prozess der Hartstoffschicht-Bildung durch erfindungsgemäßes CVD-Verfahren mit vorheriger Aufbereitung des Trennmittels
- Fig. 4:: Schliffbild der Hartstoffschicht, die durch CVD-Verfahren aus dem Stand der Technik ohne vorherige Aufbereitung des Trennmittels erzeugt wurde
- Fig. 5:: Schliffbild der Hartstoffschicht, die durch das erfindungsgemäße CVD-Verfahren durch erfindungsgemäßes CVD-Verfahren mit vorheriger Aufbereitung des Trennmittels erzeugt wurde

Beispiele aus dem bisherigen Stand der Technik und Ausführungsbeispiele des erfindungsgemäßen Verfahrens zur Herstellung eines mit einer Hartstoffschicht beschichteten Metallbauteils und eines mit einer Hartstoffschicht beschichteten Metallbauteils sind in den Zeichnungen schematisch vereinfacht dargestellt und werden in der nachfolgenden Beschreibung näher erläutert.

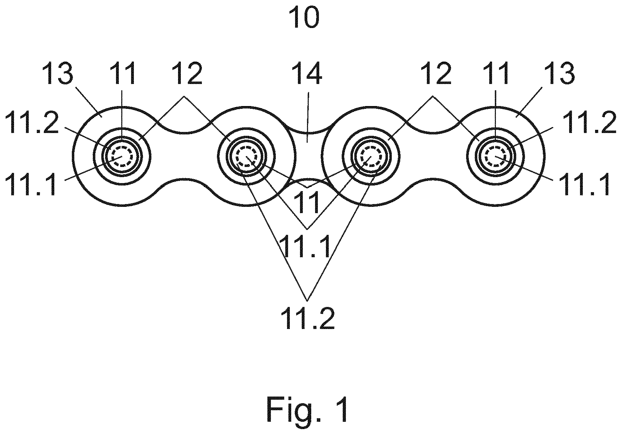

Fig. 1 zeigt zwei Kettenglieder einer aus dem Stand der Technik bekannten Kette 10, die z.B. in Kettenantrieben eingesetzt werden kann. Die Kette 10 ist als Hülsenkette ausgeführt, mit jeweils über ein Kettengelenk verbundenen Innenkettengliedern und Außenkettengliedern. Das Innenkettenglied besteht hierbei aus jeweils zwei parallel verlaufenden Innenlaschen 13 und zwei die Innenlaschen 13 miteinander verbindenden Hülsen 12, wobei die Hülsen 12 senkrecht zu den Innenlaschen 13 stehen.

Die Außenkettenglieder 14 bestehen aus zwei parallel verlaufenden Außenlaschen 14, die mit zwei Bolzen 11 miteinander verbunden sind, wobei die Bolzen 11 drehbar in den Hülsen 12 der Innenkettenglieder 13 gelagert sind. Das Außenkettenglied 14 ist durch den Bolzen 11 drehbar an einem angrenzenden Innenkettenglied 13 befestigt und verbindet durch die Außenlaschen 14 das Innenkettenglied 13 mit einem zweiten Innenkettenglied 13, wobei die Außenlaschen 14 parallel zu den Innenlaschen 13 verlaufen. Die Bolzen 11 des Außenkettenglieds 14 sind in den Hülsen 12 des Innenkettenglieds 13 drehbar gelagert, wodurch die Verbindung jeweils ein Kettengelenk der Kette 10 bildet. Die Bolzen 11 der Kette 10 bestehen vollständig aus einem Stahl, z.B. 100Cr6, wobei die Gelenkfläche des Bolzens 11 mit einer in einem CVD-Verfahren aufgetragenen Hartstoffschicht versehen ist. Alternativ oder zusätzlich kann auch die Hülse 12 aus einem Stahl hergestellt sein und auf ihrer Gelenkfläche bzw. der Lagerfläche mit einer CVD-Hartstoffschicht versehen sein.

Beispielhaft wird im Folgenden das erfindungsgemäße Beschichtungsverfahren von Bolzen 11 bestehend aus einem Stahl 100Cr6 eines Kettengliedes beschrieben. Das Trennmittel 1 wird vor dem Beginn des Beschichtungsprozesses gewaschen, sedimentiert und getrocknet, um den Feinanteil abzutrennen.

Zum Vergleich wird das Beschichtungsverfahren an den gleichen Substraten mit einem Trennmittel 1 durchgeführt, das nicht aufbereitet wurde, wie es aus dem Stand der Technik bekannt ist. Das Trennmittel ist in beiden Fällen Al₂O₃. Das nicht aufbereitete Trennmittel 1 zeigt in der Siebanalyse folgende Teilchengrößenverteilung: 0-5 % > 0,2 mm, 5-15% 0,125-0,2 mm, 65-80% 0,063-0,125 mm, 0-15% 0,04-0,063 mm, 0-10% < 0,04 mm. Den größten Anteil im Trennmittel 1 bilden danach Partikel mit einer Teilchengröße von 63 - 125 µm. Zusätzlich ist noch Ammoniumchlorid als Aktivator 2 mit einem Anteil von 0,4 % hinzugefügt.

Die Bolzen 11 werden für beide Ausführungsbeispiele mittels Härten vorbehandelt. 80 kg Bolzen 11 werden jeweils mit 37 kg Pulver und 37 kg Trennmittel vermengt und in einem Drehrohr bei 7 U/min und 950 °C in einer sauerstofffreien Stickstoffatmosphäre bei Normaldruck 6 Stunden beschichtet. Das Pulver weist zwischen 20 und 30 % Fe sowie 70 bis 80 % V auf. Nach dem Beschichten werden die Bolzen 11 in einer Luftkühlkammer abgekühlt. Ziel des Beschichtungsverfahrens ist eine möglichst homogene VC-Hartstoffschicht mit einem möglichst geringen Anteil Trennmittel 1.

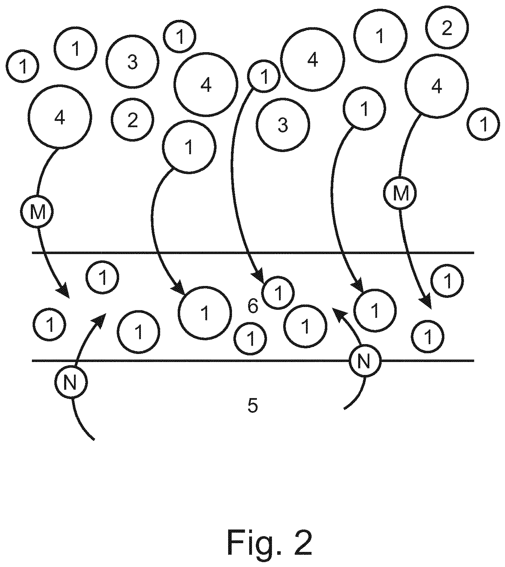

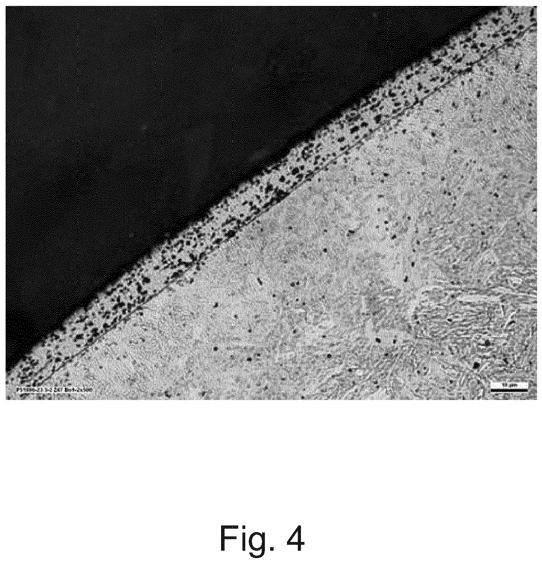

Fig. 2 zeigt schematisch den Prozess der Hartstoffschichtbildung während des CVD-Prozesses, wie aus dem Stand der Technik bekannt. Das Pulver weist die Bestandteile Trennmittel 1, Aktivator 2, Fe 3 sowie V 4 auf. Das vor dem Beschichtungsprozess gehärtete Bulkmaterial 5 wird während des CVD-Prozesses mit einer Hartstoffschicht 6 versehen. Die Hartstoffschicht 6 wird durch das Metall aus dem Pulver stammend und dem Kohlenstoff aus dem Bulkmaterial 5 stammend gebildet. Außerdem werden Partikel des Trennmittels 1 in die Hartstoffschicht 6 eingebaut. Die Teilchengröße der Partikel des Trennmittels 1 variieren stark, angedeutet durch unterschiedliche Durchmesser der Partikel. Außerdem ist der Anteil des Trennmittels 1 in der Hartstoffschicht 6 hoch, angedeutet durch die Anzahl der Partikel des Trennmittels 1. Diese schematische Darstellung wird durch das Schliffbild (Fig. 4) bestätigt.

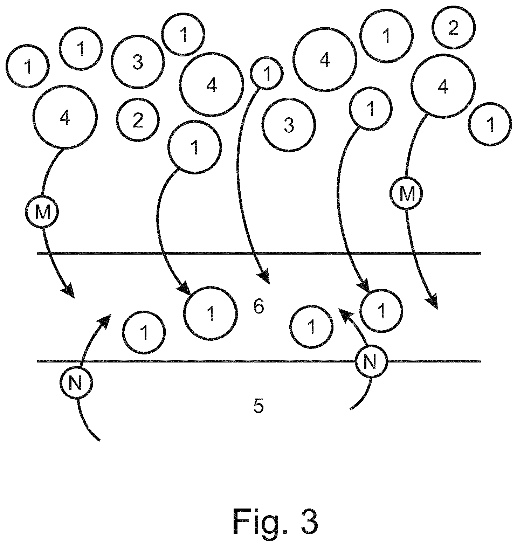

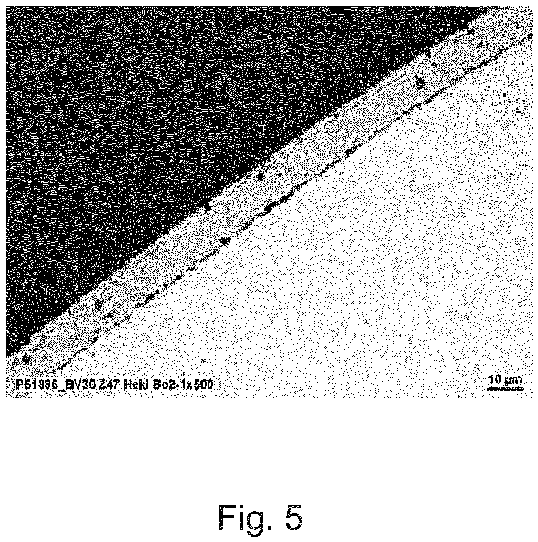

In Fig. 3 ist ein Prozess der Hartstoffschichtbildung während des erfindungsgemäßen Verfahrens dargestellt. Das Pulver weist die Bestandteile Trennmittel 1, Aktivator 2, Fe 3 sowie V 4 auf. Das Bulkmaterial 5 wird während des CVD-Prozesses mit einer Hartstoffschicht 6 versehen. Die Hartstoffschicht 6 wird durch das Metall aus dem Pulver stammend und dem Kohlenstoff aus dem Bulkmaterial 5 stammend gebildet. Partikel des Trennmittels 1 werden ebenfalls in die Hartstoffschicht 6 eingebaut. Allerdings ist die Teilchengrößenverteilung der Partikel des Trennmittels 1 geringer als im vorherigen Ausführungsbeispiel, eine Folge der Vorbehandlung des Trennmittels 1 durch Waschen, Sedimentation und Trocknen. Die kleineren Korngrößen des Trennmittels 1 wurden durch den Aufbereitungsprozess abgetrennt. Das aufbereitete Trennmittel 1 zeigt in der Siebanalyse folgende Teilchengrößenverteilung: 0-5 % > 0,2 mm, 5-15% 0,125-0,2 mm, 65-80% 0,063-0,125 mm, 0-10% 0,04-0,063 mm, 0-5% < 0,04 mm. Ebenso ist der Anteil des Trennmittels 1 in der Hartstoffschicht 6 deutlich geringer. Diese schematische Darstellung wird durch das Schliffbild (Fig. 5) bestätigt.

Fig. 4 zeigt ein Schliffbild der Hartstoffschicht 6 auf einem Bolzen 11, wie sie durch das aus dem Stand der Technik bekannte Verfahren erzeugt wurde, also ohne eine Aufbereitung des Trennmittels 1. Die Schichtdicke der Hartstoffschicht 6 beträgt hier weniger als 10 µm. Zusätzlich sind Einlagerungen des Trennmittels 1 in der Hartstoffschicht 6 vorhanden, erkennbar durch die dunkle Färbung. Der Flächenanteil des Trennmittels 1 in der Hartstoffschicht beträgt ca. 18 %, der Durchmesser schwankt zwischen 0,1 und 2 µm.

Fig. 5 zeigt ein Schliffbild der Hartstoffschicht 6 auf einem Bolzen 11, wie sie durch das erfindungsgemäße Verfahren erzeugt wurde, also mit einer Aufbereitung des Trennmittels 1 durch Waschen, Sedimentation und Trocknen. Die Schichtdicke der Hartstoffschicht 6 beträgt in diesem Ausführungsbeispiel weniger als 10 µm. Zusätzlich sind Einlagerungen des Trennmittels 1 in der Hartstoffschicht 6 vorhanden, erkennbar durch die dunkle Färbung. Der Flächenanteil des Trennmittels 1 in der Hartstoffschicht 6 beträgt ca. 2,5 %, der Durchmesser schwankt zwischen 0,1 und 2 µm. Der Anteil des Trennmittels 1 in der Hartstoffschicht 6 ist erheblich geringer als ohne eine vorherige Aufbereitung des Trennmittels 1. Das erfindungsgemäße Verfahren erzeugt also eine deutlich homogenere Hartstoffschicht 6 durch die Verwendung von aufbereiteten Trennmitteln und hier insbesondere von Trennmitteln, deren Feinstbestandteile aus dem verwendeten Pulver abgetrennt wurden, als die bisher aus dem Stand der Technik bekannten Lösungen.

In einem weiteren Ausführungsbeispiel werden die Bolzen 11 mittels Härten vorbehandelt. 80 kg Bolzen 11 werden jeweils mit 40 kg FeCr-Pulver und 30 kg Trennmittel hier Al₂O₃ vermengt und in einem Drehrohr bei 7 U/min und 950 °C in einer sauerstofffreien Stickstoffatmosphäre bei Normaldruck 6 Stunden beschichtet. Das Pulver weist zwischen 20 und 30 % Fe sowie 70 bis 80 % Cr auf. Nach dem Beschichten werden die Bolzen 11 in einer Luftkühlkammer abgekühlt. Ziel des Beschichtungsverfahrens ist eine möglichst homogene CrN-Hartstoffschicht mit einem möglichst geringen Anteil Trennmittel 1.

Das Pulver weist in diesem Ausführungsbeispiel die Bestandteile Trennmittel 1, Aktivator 2, Fe 3 sowie Cr 4 auf. Das Substratmaterial 5 ist ein kohlenstoffhaltiger Stahl und wird während des CVD-Prozesses mit einer Hartstoffschicht 6 versehen. Die Hartstoffschicht 6 wird durch das Metall aus dem Pulver stammend und dem Stickstoff aus der Atmosphäre stammend gebildet. Partikel des Trennmittels 1 werden ebenfalls in die Hartstoffschicht 6 eingebaut. Durch Waschen, Sedimentation und Trocknen wurde das Trennmittel 1 aufbereitet und Anteile der Fraktion des Trennmittels mit den kleinen Partikelgrößen abgetrennt. Das verbleibende Trennmittel-Pulver wurde in der Pulvermischung des CVD-Prozesses verwendet. Das aufbereitete Trennmittel 1 zeigt in der Siebanalyse folgende Teilchengrößenverteilung: 0-5 % > 0,2 mm, 5-15% 0,125-0,2 mm, 65-80% 0,063-0,125 mm, 0-10% 0,04-0,063 mm, 0-5% < 0,04 mm. Der Anteil des Trennmittels 1 in der Hartstoffschicht 6 ist sehr gering. Eine EDX-Analyse ergab 4,5 Atom% Al-Anteil in der Hartstoffschicht.

### BEZUGSZEICHENLISTE

- 1: Trennmittel
- 2: Aktivator
- 3: Metall 1
- 4: Metall 2
- 5: BulkmaterialSubstratmaterial
- 6: Hartstoffschicht
- 10: Kette
- 11: Bolzen
- 12: Hülse
- 13: Innenlasche
- 14: Außenlasche
- M: Metall
- N: Kohlenstoff

## Patentansprüche

1. Verfahren zur Herstellung eines mit einer Hartstoffschicht (6) beschichteten Kettenbauteils (11, 12, 13, 14), wie beispielsweise eine Innen- (13) und/oder Außenlasche (14), Hülse (12) und/oder Bolzen (11), das folgende Verfahrensschritte aufweist:
• Aufbereiten eines Trennmittels 1
• Zufügen des aufbereiteten Trennmittels 1 zu einer Pulvermischung
• Bereitstellen der Pulvermischung,
• Bereitstellen des Substrats (5) aus Metall,
• Heizen des Pulvers und des Substrats (5) in einer Heizvorrichtung,
• Abscheiden einer Schicht auf dem Substrat (5),
wobei die Schicht (5) eine höhere Härte aufweist als das Substrat (5)
• Abkühlen des Substrats (5),
wobei der Anteil des Trennmittels (1) an der Pulvermischung kleinergleich 25 Gew.-% ist, und
wobei der Verfahrensschritt Aufbereiten eines Trennmittels (1) zu einer Vergrößerung der mittleren Teilchengröße des Trennmittels (1) führt,
wobei die Veränderung der Teilchengrößenverteilung des Trennmittels (1) durch Waschen, Sieben, Sedimentation, Filtrieren, Sichten, Windsichten und/oder Zentrifugieren, erfolgt,
wobei das Trennmittel (1) einen Anteil an Partikeln kleiner 40 µm von weniger als 25%, bevorzugt weniger als 15% und besonders bevorzugt weniger als 10% beinhaltet,
wobei die Teilchengrößenverteilung des Trennmittels durch eine Siebanalyse ermittelt wird,
wobei das Trennmittel Al₂O₃, Kaolin (Aluminiumsilikat), Mullit (Aluminium- und Siliciumoxid), Zirkonoxid, nitridische und/oder silicide Keramiken und/oder sämtliche weitere keramische inerte Substanzen beinhaltet und wobei die Prozesstemperatur zeitweise höher ist als 450°C, bevorzugt größer als 500°C und besonders bevorzugt größer als 550°C.

2. Verfahren zur Herstellung eines mit einer Hartstoffschicht (6) beschichteten Kettenbauteils (11, 12, 13, 14) nach Anspruch 1
**dadurch gekennzeichnet, dass**
das Substrat (5) aus einem Stahl ist und/oder die Hartstoffschicht (6) eine CrN-, FeN-, und/oder VN-Schicht aufweist.

3. Verfahren zur Herstellung eines mit einer Hartstoffschicht (6) beschichteten Kettenbauteils (11, 12, 13, 14) nach Anspruch 1 oder 2
**dadurch gekennzeichnet, dass**
das Trennmittel (1) einen Anteil an Partikeln kleiner 10µm von weniger als 20%, bevorzugt weniger als 12% und besonders bevorzugt weniger als 8% beinhaltet.

4. Metallbauteil beschichtet mit einer Hartstoffschicht (6) mit:
• einem Substrat (5) aus Stahl
• einer Hartstoffschicht (6) aus einem Metallcarbid und/oder einem Metallnitrid oder Mischungen davon,
wobei die Hartstoffschicht (6) Partikel eines Trennmittels (1) aufweist,
**dadurch gekennzeichnet, dass**
in einem Schliffbild der Hartstoffschicht (6) der Flächenanteil der Partikel des Trennmittels (1) in der Hartstoffschicht (6) kleiner als 15%, bevorzugt kleiner als 10% und besonders bevorzugt kleiner als 5% ist,
wobei das Metallbauteil ein Kettenbauteil (11, 12, 13, 14) wie beispielsweise eine Innen- (13) und/oder Außenlasche (14), Hülse (12) und/oder Bolzen (11) ist.

## Claims

1. A process for producing a chain component coated with a hard material layer (6) chain component (11, 12, 13, 14), such as an inner (13) and/or outer plate (14), sleeve (12) and/or pin (11), which comprises the following process steps comprising:
• preparation of a release agent (1)
• adding the prepared release agent (1) to a powder mixture
• providing the powder mixture,
• providing the substrate (5) of metal,
• heating the powder and the substrate (5) in a heating device,
• depositing a layer on the substrate (5), whereby the layer has a higher hardness than the substrate (5)
• cooling the substrate (5),
wherein the proportion of the release agent (1) in the powder mixture is less than or equal to 25% by weight, and
wherein the process step of preparing a release agent (1) leads to an increase in the average particle size of the release agent (1),
wherein the change in the particle size distribution of the release agent (1) is effected by washing, sieving, sedimentation, filtration, sifting, air sifting and/or centrifuging,
wherein the release agent (1) contains a proportion of particles smaller than 40 µm of less than 25%, preferably less than 15% and particularly preferably less than 10%,
wherein the particle size distribution of the release agent is determined by sieve analysis
wherein the release agent (1) comprises Al₂O₃, kaolin (aluminosilicate), mullite (alumina and silica), zirconia, nitride and/or silicide ceramics and/or all other ceramic inert substances, and wherein the process temperature is at times higher than 450°C, preferably higher than 500°C and particularly preferably higher than 550°C.

2. The process for producing a chain component (11, 12, 13, 14) coated with a hard material layer (6) according to claim 1,
**characterized in that**
the substrate (5) is made of a steel and/or the hard material layer (6) has a CrN, FeN and/or VN layer.

3. The process for producing a chain component (11, 12, 13, 14) coated with a hard material layer (6) according to claim 1 or 2,
**characterized in that**
the release agent (1) contains a proportion of particles smaller than 10µm of less than 20%, preferably less than 12% and particularly preferably less than 8%.

4. A metal component coated with a hard material layer (6) with:
• a substrate (5) of steel
• a hard material layer (6) of a metal carbide and/or a metal nitride or mixtures thereof,
wherein the hard material layer (6) comprises particles of a release agent (1),
**characterized in that** in a micrograph of the hard material layer (6) the area fraction of the particles of the release agent (1) in the hard material layer (6) is less than 15%, preferably less than 10% and particularly preferably less than 5%,
wherein the metal component is a chain component (11, 12, 13, 14) such as an inner (13) and/or outer flap (14), sleeve (12) and/or pin (11).

## Revendications

1. Procédé de fabrication d'un composant de chaîne (11, 12, 13, 14) revêtu d'une couche de matériau dur (6), tel qu'une languette intérieure (13) et/ou extérieure (14), un manchon (12) et/ou un boulon (11), présentant les étapes de procédé suivantes :
• préparation d'un agent de démoulage (1)
• ajout de l'agent de démoulage préparé (1) à un mélange de poudre
• fourniture du mélange de poudre,
• fourniture du substrat (5) en métal,
• chauffage de la poudre et du substrat (5) dans un dispositif de chauffage,
• dépôt d'une couche sur le substrat (5) dans lequel la couche présente une dureté plus élevée que le substrat (5)
• refroidissement du substrat (5),
dans lequel la proportion de l'agent de démoulage (1) dans le mélange de poudre est inférieure ou égale à 25 % en poids, et
dans lequel l'étape de procédé de préparation d'un agent de démoulage (1) conduit à une augmentation de la taille moyenne des particules de l'agent de démoulage (1),
dans lequel la répartition granulométrique de l'agent de démoulage (1) est modifiée par lavage, tamisage, sédimentation, filtration, criblage, séparation à air et/ou centrifugation,
dans lequel l'agent de démoulage (1) contient une proportion de particules inférieures à 40 µm de moins de 25 %, de préférence de moins de 15 % et de manière particulièrement préférée de moins de 10 %, dans lequel la répartition granulométrique de l'agent de démoulage est déterminée par analyse au tamis,
dans lequel l'agent de démoulage (1) contient de l'Al₂O₃, du kaolin (silicate d'aluminium), de la mullite (alumine et silice), du zircone, des céramiques nitrurées et/ou siliciées et/ou toutes autres substances céramiques inertes, et dans lequel la température du procédé est temporairement supérieure à 450 °C, de préférence supérieure à 500 °C et de manière particulièrement préférée supérieure à 550 °C.

2. Procédé de fabrication d'un composant de chaîne (11, 12, 13, 14) revêtu d'une couche de matériau dur (6) selon la revendication 1
**caractérisé en ce que**
le substrat (5) est en acier et/ou la couche de matériau dur (6) présente un CrN, FeN, et VN-couche.

3. Procédé de fabrication d'un composant de chaîne (11, 12, 13, 14) revêtu d'une couche de matériau dur (6) selon la revendication 1 ou 2
**caractérisé en ce que**
l'agent de démoulage (1) contient une proportion de particules inférieures à 10 µm de moins de 20 %, de préférence de moins de 12 % et de manière particulièrement préférée de moins de 8 %.

4. Composant métallique revêtu d'une couche de matériau dur (6) comportant :
• un substrat (5) en acier
• une couche de matériau dur (6) constituée d'un carbure métallique et/ou d'un nitrure métallique ou leurs mélanges,
dans lequel la couche de matériau dur (6) présente des particules d'un agent de démoulage (1),
**caractérisé en ce que**
dans une micrographie de la couche de matériau dur (6), la surface des particules de l'agent de démoulage (1) dans la couche de matériau dur (6) est inférieure à 15 %, de préférence à 10 % et de manière particulièrement préférée à 5 %,
dans lequel le composant métallique est un composant de chaîne (11, 12, 13, 14) tel qu'une languette intérieure (13) et/ou extérieure (14), un manchon (12) et/ou un boulon (11).
